(19) Europäisches Patentamt

European Patent Office

Office européen des brevets

(11) **EP 3 026 674 B1**

(12) **EUROPEAN PATENT SPECIFICATION**

(45) Date of publication and mention
of the grant of the patent:
**21.04.2021   Bulletin 2021/16**

(21) Application number: **14843591.0**

(22) Date of filing: **14.02.2014**

(51) Int Cl.:
*H01B 1/22* (2006.01)          *H01B 1/16* (2006.01)
*H01L 31/042* (2014.01)          *H01L 31/0224* (2006.01)
*H01L 31/18* (2006.01)

(86) International application number:
**PCT/KR2014/001223**

(87) International publication number:
**WO 2015/037798 (19.03.2015 Gazette 2015/11)**

(54) **COMPOSITION FOR FORMING SOLAR CELL ELECTRODE, AND ELECTRODE PRODUCED FROM COMPOSITION**

ZUSAMMENSETZUNG ZUR BILDUNG EINER SOLARZELLENELEKTRODE UND AUS DER ZUSAMMENSETZUNG HERGESTELLTE ELEKTRODE

COMPOSITION POUR FORMER UNE ÉLECTRODE DE CELLULE SOLAIRE ET ÉLECTRODE FABRIQUÉE À PARTIR DE LA COMPOSITION

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **13.09.2013   KR 20130110719**
**13.02.2014   KR 20140016947**

(43) Date of publication of application:
**01.06.2016   Bulletin 2016/22**

(73) Proprietor: **Samsung SDI Co., Ltd.**
**Yongin-si, Gyeonggi-do 17084 (KR)**

(72) Inventors:
• **SONG, Dae Sub**
**Uiwang-si**
**Gyeonggi-do 437-711 (KR)**
• **KIM, Jae Ho**
**Uiwang-si**
**Gyeonggi-do 437-711 (KR)**
• **YANG, Sang Hyun**
**Uiwang-si**
**Gyeonggi-do 437-711 (KR)**
• **CHOI, Young Wook**
**Uiwang-si**
**Gyeonggi-do 437-711 (KR)**

(74) Representative: **Michalski Hüttermann & Partner Patentanwälte mbB**
**Speditionstraße 21**
**40221 Düsseldorf (DE)**

(56) References cited:
**EP-A2- 2 490 228          WO-A1-2012/135551**
**WO-A2-2009/157727          JP-A- 2004 355 862**
**JP-A- 2011 228 481          JP-A- 2012 023 088**
**KR-A- 20070 055 489          KR-A- 20090 110 739**
**KR-A- 20100 000 685          KR-A- 20100 069 950**

Remarks:
The file contains technical information submitted after the application was filed and not included in this specification

EP 3 026 674 B1

**Description**

[Technical Field]

The present invention relates to a method of manufacture composition for solar cell electrodes and electrodes produced using the same. More specifically, the present invention relates to a composition for solar cell electrodes obtained by the method of manufacture according to the invention, which can be printed in fine linewidth and high aspect ratio on a substrate by screen-printing and has high conversion efficiency, and electrodes produced using the same.

[Background Art]

Solar cells generate electricity using the photovoltaic effect of a p-n junction which converts photons of sunlight into electricity. In the solar cell, front and rear electrodes are formed on upper and lower surfaces of a semiconductor wafer or substrate with the p-n junctions, respectively. Then, the photovoltaic effect at the p-n junction is induced by sunlight entering the semiconductor wafer and electrons generated by the photovoltaic effect at the p-n junction provide electric current to the outside through the electrodes. The electrodes of the solar cell are formed on the wafer by applying, patterning, and baking an electrode composition.

Generally, a method of printing a composition for solar cell electrodes on a substrate can be divided into gravure offset printing and screen-printing. Particularly, it is important to use a composition for solar cell electrode that can be printed in fine linewidth and high aspect ratio on a substrate. Gravure offset printing is significantly influenced by viscosity, dryness, and adhesion of the composition. And screen-printing is significantly influenced by rheology or thixotrophy.

WO 2012/135551 A1 refers to a high-aspect ratio printable thick film metal paste compositions that can be deposited onto a substrate using, for example, screening printing techniques; and methods of preparing and using thick film printable metal pastes; and methods of screen printing of the thick film metal paste compositions onto a substrate to produce printed circuits, conductive lines or features on the substrate and/or a conductive surface on a solar cell device.

EP 2 490 228 A2 refers to a silver paste composition and a solar cell using the same. The silver paste composition is applied on an anti-reflection film, and includes silver powder, glass frit powder, an organic binder and a plasticizer. The silver paste composition for forming a front electrode of a solar cell has a uniform printed pattern and good affinity for a substrate.

WO 2009/157727 A2 refers to a conductive paste composition comprising a binder resin, a diluent, a conductive metal material, glass frit, and an inorganic thixotrophic agent, which is useful for preparing an electrode of a solar cell and it prevents the the deformation of an electrode after a heat-treating process, thereby increasing a light-receiving region and photoelectric conversion efficiency.

JP 2011 228481 A refers to a conductive paste capable of forming a jumper wiring which can cope with conductor wiring of high-density, make a circuit pitch minute, secure high connection reliability, also realize thinning of a flexible printed-wiring board, the flexible printed-wiring board which has the jumper wiring formed by the conductive paste, and electronic equipment having the flexible printed-wiring board.

JP 2004 355862 A refers to a paste for conductor which does not cause troubles in post processes and is excellent in printing property, and to provide a manufacturing method for a ceramic wiring board and the ceramic wiring board.

Korean Patent Publication No. 2011-0040713A discloses a composition that adjusts a leveling property and thixotrophy by using a plasticizer to realize narrow linewidth and high aspect ratio. Korean Patent Publication No. 2010-0069950A discloses gravure offset printing method which employs a binder having a high glass transition temperature (Tg) for bi-layer electrodes in order to realize high aspect ratio. Korean Patent Publication No. 2007-0055489A suggests adjusting particle size of silver (Ag) powder to control thixotrophy (TI). However, it is still difficult to realize a printed pattern in fine linewidth and high aspect ratio.

[Disclosure]

[Technical Problem]

It is one aspect of the present invention to provide a composition for solar cell electrodes obtained by the method of manufacture according to the invention, which can realize a printed pattern in fine linewidth and high aspect ratio.

It is another aspect of the present invention to provide a composition for solar cell electrodes obtained by the method of manufacture according to the invention, which has high conversion efficiency.

The above and other aspect and features of the present invention can be accomplished by the present invention described hereinafter.

[Technical Solution]

One aspect of the present invention relates to a method of manufacture a composition for solar cell electrodes comprising mixing:

- 50 wt% to 90 wt% of a conductive powder, wherein the conductive powder comprises at least one selected from the group consisting of silver (Ag), gold (Au), palladium (Pd), platinum (Pt), copper (Cu), chromium (Cr), cobalt (Co), aluminum (Al), tin (Sn), lead (Pb), zinc (Zn), iron (Fe), iridium (Ir), osmium (Os), rhodium (Rh), tungsten (W), molybdenum (Mo), nickel (Ni), and indium tin oxide (ITO),
- 1 wt% to 15 wt% of a glass frit, wherein the glass frit comprises leaded glass frits, lead-free glass frits, or mixtures thereof,
- 3 wt% to 40 wt% of an organic vehicle, wherein the organic vehicle comprises a binder resin and a solvent, and
- 0.01 wt% to 2 wt% of a thixotropic agent, wherein the thixotropic agent comprises at least one selected from the group consisting of amine compounds, castor oil compounds, carbon black compounds, fatty acid amide compounds, fumed silica compounds, organo clay compounds, and nano-scale organic/inorganic particles, wherein the method steps of the composition satisfying the following Formulae 1 to 7:

[Formula 1]

$$3 < \text{TI } 10 = (\text{viscosity at 1 rpm/viscosity at 10 rpm}) < 5.5;$$

[Formula 2]

$$4 < \text{TI } 20 = (\text{viscosity at 2 rpm/viscosity at 20 rpm}) < 7;$$

[Formula 3]

$$6 < \text{TI } 50 = (\text{viscosity at 5 rpm/viscosity at 50 rpm}) < 7.5;$$

[Formula 4]

$$6 < \text{TI } 100 = (\text{viscosity at 10 rpm/viscosity at 100 rpm}) < 7.5;$$

[Formula 5]

$$1 < |\text{TI 10-TI 20}| < 2;$$

[Formula 6]

$$0.5 < |\text{TI 20-TI 50}| < 1.5;$$

and

[Formula 7]

$$0 \leq |\text{TI 50-TI 100}| < 0.8,$$

where in formulae 1 to 7, a thixotropic index (TI) is calculated by substituting viscosity values measured at each revolutions per minute (rpm) using a No. 14 spindle by a rotary viscometer at 23°C, after temperature stabilization for 5 minutes, viscosity is measured at the following maintenance time 1 rpm 60 sec, 2 rpm 30 sec, 5 rpm 15 sec, 10 rpm 15 sec, 20 rpm 15 sec, 50 rpm 15 sec and 100 rpm 15 sec.

Other aspect of the present invention to provide solar cell electrodes fabricated using the same.

[Advantageous Effects]

The method of manufacture of the composition for solar cell electrodes of the present invention provides composition that can realize a printed pattern in fine linewidth and high aspect ratio, and has high conversion efficiency.

[Description of Drawings]

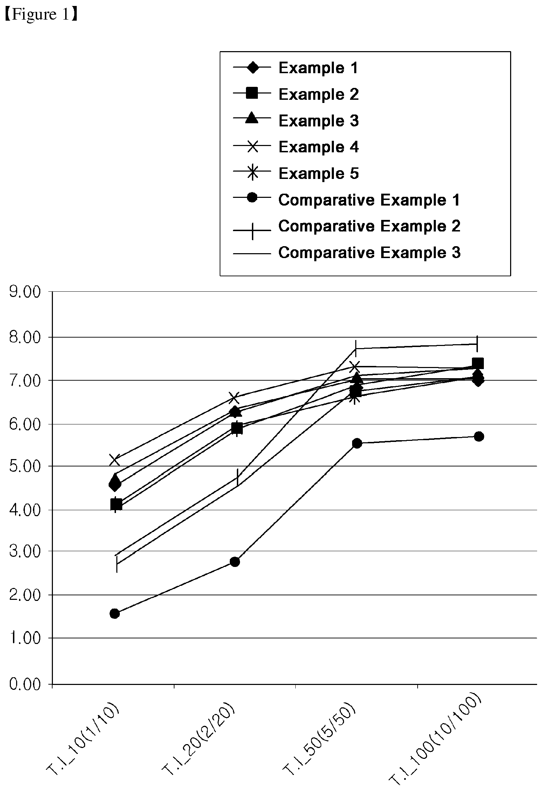

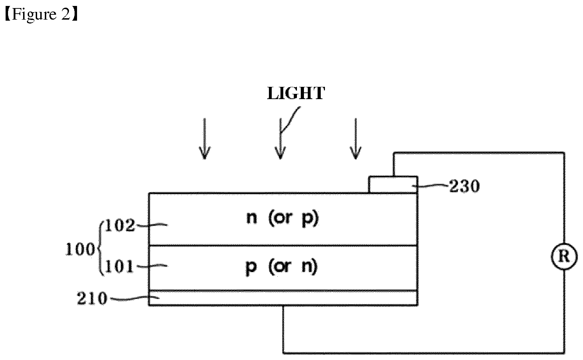

Fig. 1 illustrates a graph representing TI values measured in Examples 1 to 5 and Comparative Examples 1 to 3. Fig. 2 illustrates a schematic view of a solar cell structure in accordance with one embodiment obtained by the method of manufacture of the present invention.

[Best Mode]

One aspect of the present invention relates to a method of manufacture a composition for solar cell electrodes, wherein the composition for solar cell electrodes obtained by said method of manufacture includes a conductive powder, a glass frit, an organic vehicle and a thixotropic agent, and satisfies the following Formulae 1 to 7.

[Formula 1]

$$3 < TI\ 10 = (viscosity\ at\ 1\ rpm/viscosity\ at\ 10\ rpm) < 5.5$$

[Formula 2]

$$4 < TI\ 20 = (viscosity\ at\ 2\ rpm/viscosity\ at\ 20\ rpm) < 7$$

[Formula 3]

$$6 < TI\ 50 = (viscosity\ at\ 5\ rpm/viscosity\ at\ 50\ rpm) < 7.5$$

[Formula 4]

$$6 < TI\ 100 = (viscosity\ at\ 10\ rpm/viscosity\ at\ 100\ rpm) < 7.5$$

[Formula 5]

$$1 < |TI\ 10-TI\ 20| < 2$$

[Formula 6]

$$0.5 < |TI\ 20-TI\ 50| < 1.5$$

[Formula 7]

$$0 \le |TI\ 50-TI\ 100| < 0.8$$

In Formulae 1 to 7, thixotropic index (TI) is calculated by substituting viscosity values measured at each revolutions per minute (rpm) using a No. 14 spindle by a rotary viscometer at 23°C.

The composition may include about 50 wt% to about 90 wt% of the conductive powder; about 1 wt% to about 15 wt% of the glass frit; about 3 wt% to about 40 wt% of the organic vehicle; and about 0.01 wt% to about 2 wt% of the thixotropic agent.

The conductive powder may include at least one selected from the group consisting of silver (Ag), gold (Au), palladium (Pd), platinum (Pt), copper (Cu), chromium (Cr), cobalt (Co), aluminum (Al), tin (Sn), lead (Pb), zinc (Zn), iron (Fe), iridium (Ir), osmium (Os), rhodium (Rh), tungsten (W), molybdenum (Mo), nickel (Ni), and indium tin oxide (ITO).

The glass frit may include leaded glass frits, lead-free glass frits, or mixtures thereof.

The thixotropic agent may include at least one compound selected from the group consisting of amine compounds, castor oil compounds, carbon black compounds, fatty acid amide compounds, fumed silica compounds, organo clay compounds, and nano-scale organic/inorganic particles.

The glass frit may have an average particle diameter (D50) of about 0.1 $\mu$m to about 5 $\mu$m.

The composition may further include at least one additive selected from the group consisting of dispersants, plasticizers, viscosity stabilizers, anti-foaming agents, pigments, UV stabilizers, antioxidants, and coupling agents.

A pattern printed with the composition has a linewidth of about 75 $\mu$m to about 90 $\mu$m, a line thickness of about 15 $\mu$m to about 20 $\mu$m, and an aspect ratio (line thickness/linewidth) of 0.15 or more.

Other aspect of the present invention to provide solar cell electrodes fabricated using the same.

[Mode for Invention]

Hereinafter in the following exemplary embodiments, each component obtained by the method of manufacture of the invention will be described in more details. Indeed, exemplary embodiments are provided for understanding of the invention and not limited to the embodiments set forth herein. The other details not described in this application are easy to inferred to person skilled in the relevant field of technology, thereby can be omitted.

## Composition for solar cell electrodes

A composition for solar cell electrodes obtained by the method of manufacture according to the invention includes a conductive powder (A), a glass frit (B), an organic vehicle (C) and a thixotropic agent (D), and can be printed in fine linewidth on a substrate by screen-printing, and has high conversion efficiency.

Hereinafter, embodiments obtained by the method of manufacture according to the present invention will be described in detail.

### (A) Conductive powder

As the conductive powder, any organic or inorganic powder having conductivity may be used. Preferably, the conductive powder includes silver (Ag), gold (Au), palladium (Pd), platinum (Pt), copper (Cu), chromium (Cr), cobalt (Co), aluminum (Al), tin (Sn), lead (Pb), zinc (Zn), iron (Fe), iridium (Ir), osmium (Os), rhodium (Rh), tungsten (W), molybdenum (Mo), nickel (Ni), or indium tin oxide (ITO) powder. These conductive powders may be used alone or in combination of two or more thereof. The conductive powder preferably includes silver (Ag) particle, and may further include nickel (Ni), cobalt (Co), iron (Fe), zinc (Zn) or copper (Cu) particles.

The conductive powder may have an average particle diameter (D50) of about 0.1 $\mu$m to about 10 $\mu$m. The conductive powder preferably has an average particle diameter of about 0.2 $\mu$m to about 7 $\mu$m, more preferably about 0.5 $\mu$m to about 5 $\mu$m.

The conductive powder may be present in an amount of about 50 wt% to about 90 wt% based on the total weight of the composition. The conductive powder is preferably present in an amount of about 70 wt% to about 90 wt%. Within this range, the conductive powder can prevent deterioration in conversion efficiency due to resistance increase, can prevent having difficulty in forming the paste due to relative reduction in amount of the organic vehicle, and while providing suitable dispersion, fluidity and printability to the composition.

### (B) Glass frit

The glass frits may generate silver crystal grains in an emitter region by etching an anti-reflection layer and melting the silver powder so as to reduce contact resistance during the baking process of the paste for electrodes. Further, the glass frits serve to enhance adhesion between the conductive powder and the wafer and are softened to decrease the baking temperature during the baking process.

When the area of the solar cell is increased in order to improve efficiency or fill factor of the solar cell, a contact resistance of the solar cell may increase. Thus, it is necessary to minimize both serial resistance and damage on the p-n junction. In addition, as the baking temperatures varies within a broad range with increasing use of various wafers having different sheet resistances, it is desirable that the glass frits secure sufficient thermal stability to withstand a wide range of baking temperatures.

The glass frit may be at least one of leaded glass frits and lead-free glass frits, which are typically used in compositions for solar cell electrodes.

The glass frit may include one or mixture of two or more metal oxide such as lead oxide, silicon oxide, tellurium oxide, bismuth oxide, zinc oxide, boron oxide, aluminum oxide, tungsten oxide, etc. For example, the glass frit may include zinc oxide-silicon oxide ($ZnO$-$SiO_2$), zinc oxide-boron oxide-silicon oxide ($ZnO$-$B_2O_3$-$SiO_2$), zinc oxide-boron oxide-silicon oxide-aluminum oxide ($ZnO$-$B_2O_3$-$SiO_2$-$Al_2O_3$), bismuth oxide-silicon oxide ($Bi_2O_3$-$SiO_2$), bismuth oxide-boron oxide-silicon oxide ($Bi_2O_3$-$B_2O_3$-$SiO_2$), bismuth oxide-boron oxide-silicon oxide-aluminum oxide ($Bi_2O_3$-$B_2O_3$-$SiO_2$-$Al_2O_3$), bismuth oxide-zinc oxide-boron oxide-silicon oxide ($Bi_2O_3$-$ZnO$-$B_2O_3$-$SiO_2$), bismuth oxide-zinc oxide-boron oxide-silicon oxide-aluminum oxide ($Bi_2O_3$-$ZnO$-$B_2O_3$-$SiO_2$-$Al_2O_3$) glass frits, and the like.

The glass frit may be prepared from such metal oxides by any typical methods. For example, the metal oxides may be mixed in a predetermined ratio. Mixing may be carried out using a ball mill or a planetary mill. The mixture is melted at about 900°C to about 1300°C, followed by quenching to about 25°C. The obtained resultant is subjected to pulverization using a disc mill, a planetary mill, or the like, thereby preparing a glass frit.

The glass frit may have a spherical or amorphous shape.

The glass frit may be purchased or may be prepared by selectively melting, for example, silicon dioxide ($SiO_2$), aluminum oxide ($Al_2O_3$), boron oxide ($B_2O_3$), bismuth oxide ($Bi_2O_3$), sodium oxide ($Na_2O$), zinc oxide ($ZnO$), and the like, so as to have a desired composition.

The glass frit may be present in an amount of about 1 wt% to about 15 wt%, preferably about 2 wt% to about 10 wt%, based on the total weight of the composition. Within this content range, the glass frit can provide suitable dispersibility, fluidity and printability to the composition.

### (C) Organic vehicle

The organic vehicle imparts suitable viscosity and rheological characteristics for printing to the composition for solar cell electrodes through mechanical mixing with the inorganic component of the composition.

The organic vehicle may be any typical organic vehicle used in solar cell electrode compositions, and may include a binder resin, a solvent, and the like.

As the binder resin, acrylate resins or cellulose resins may be used. Ethyl cellulose is generally used as the binder resin. In addition, ethyl hydroxyethyl cellulose, nitro cellulose, blends of ethyl cellulose and phenol resins, alkyd resins, phenolic resins, acrylate ester resins, xylene resins, polybutene resins, polyester resins, urea resins, melamine resins, vinyl acetate resins, wood rosins, polymethacrylates of alcohols, and the like.

The solvent may be include at least one or two more of for example, hexane, toluene, ethyl cellosolve, cyclohexanone, butyl cellosolve, butyl carbitol (diethylene glycol monobutyl ether), dibutyl carbitol (diethylene glycol dibutyl ether), butyl carbitol acetate (diethylene glycol monobutyl ether acetate), propylene glycol monomethyl ether, hexylene glycol, terpineol, methylethylketone, benzylalcohol, $\gamma$-butyrolactone, ethyl lactate, and combinations thereof.

The organic vehicle may be present in an amount of about 3 wt% to about 40 wt% based on the total weight of the composition. Within this range, the organic vehicle can provide sufficient adhesive strength and excellent printability to the composition.

### (D) Thixotropic agent

The composition obtained by the method according to the present invention includes a thixotropic agent. The thixotropic agent may include at least one compound selected from the group consisting of amine compounds, castor oil compounds, carbon black compounds, fatty acid amide compounds, fumed silica compounds, organo clay compounds, and nano-scale organic/inorganic particles.

In one embodiment, examples of thixotropic agent may include THIXATROL P600 (Elementis Co.) as the amine compounds, THIXATROL ST (Elementis Co.) as the castor oil compounds, VULCAN XC72 (Cabot Co.) as the carbon black compounds, Flownon (Kyoeisha Co.) as the fatty acid amide compounds, A200 (Evonik Co.) as the fumed silica compounds, BENTONE SD-3 (Elementis Co.) as the organo clay compounds, etc.

The thixotropic agent may be present in an amount of about 0.01 wt% to about 2 wt%, preferably about 0.05 wt% to about 1 wt%, based on the total weight of the composition. Within this range, the thixotropic agent can provide sufficient adhesive strength and excellent printability to the composition.

### (E) Other additives

The composition may further include typical additives to enhance flow and process properties and stability, as needed. The additives may include dispersants, plasticizers, viscosity stabilizers, anti-foaming agents, pigments, UV stabilizers, antioxidants, coupling agents, and the like. These additives may be used alone or as mixtures thereof. These additives may be present in an amount of 0.1 wt% to 5 wt% based on the total weight of the composition, without being limited thereto.

The composition for solar cell electrodes obtained by the method according to the present invention is applicable to screen-printing, and satisfies the following Formulae 1 to 7, wherein the composition can exhibit fine pattern printability and high conversion efficiency.

[Formula 1]

$$3 < \text{TI } 10 = (\text{viscosity at 1 rpm/viscosity at 10 rpm}) < 5.5$$

[Formula 2]

$$4 < \text{TI } 20 = (\text{viscosity at 2 rpm/viscosity at 20 rpm}) < 7$$

[Formula 3]

$$6 < \text{TI } 50 = (\text{viscosity at 5 rpm/viscosity at 50 rpm}) < 7.5$$

[Formula 4]

$$6 < \text{TI } 100 = (\text{viscosity at 10 rpm/viscosity at 100 rpm}) < 7.5$$

[Formula 5]

$$1 < |\text{TI } 10\text{-TI } 20| < 2$$

[Formula 6]

$$0.5 < |\text{TI } 20\text{-TI } 50| < 1.5$$

[Formula 7]

$$0 \leq |\text{TI } 50\text{-TI } 100| < 0.8$$

In Formulae 1 to 7, a thixotropic index (TI) is calculated by substituting the viscosity values measured at each different revolutions per minute (rpm) and at 23°C with a No. 14 Spindle using a rotary viscometer.

Specifically, in Formulae 1 to 4, the thixotropic index (TI) may be defined as a ratio of viscosity values measured at different revolutions per minute(rpm) of a rotary viscometer. By way of example, the thixotropic index TI 10 means a ratio of viscosity at 1 rpm to viscosity at 10 rpm as measured using a No. 14 spindle by the rotary viscometer at 23°C, and the thixotropic index TI 20 means a ratio of viscosity at 2 rpm to viscosity at 20 rpm as measured using a No. 14 spindle by the rotary viscometer at 23°C. One example of the rotary viscometer may include HBDV-II+Pro (Brookfield Co., Ltd.).

Further, the composition for solar cell electrodes preferably has a viscosity of about 200 Pa·s to about 600 Pa·s in terms of printability. Here, the viscosity is measured by the rotary viscometer at 23°C and 10 rpm.

When the composition for solar cell electrodes obtained by the method of manufacture according to the present invention is printed on a substrate, particularly, by screen-printing, a printed pattern may have a linewidth of about 75 μm to about 90 μm and a line thickness of about 15 μm to about 20 μm. Further, the composition may provide an aspect ratio (line thickness/linewidth) of about 0.15 or more, preferably about 0.15 to about 0.20, more preferably about 0.16 to about 0.18. Within this range of aspect ratio, the composition can exhibit excellent printability.

## Solar cell electrode and solar cell including the same

Other aspects of the invention relate to an electrode formed of the composition for solar cell electrodes and a solar cell including the same. Fig. 2 shows a solar cell in accordance with one embodiment of the invention.

Referring to Fig. 2, a rear electrode 210 and a front electrode 230 may be formed by printing and baking the composition on a wafer or substrate 100 that includes a p-layer (or n-layer) 101 and an n-layer (or p-layer) 102, which will serve as an emitter. For example, a preliminary process of preparing the rear electrode is performed by printing the composition on the rear surface of the wafer and drying the printed composition at about 200°C to about 400°C for about 10 seconds to about 60 seconds. Further, a preliminary process for preparing the front electrode may be performed by printing the paste on the front surface of the wafer and drying the printed composition. Then, the front electrode and the rear electrode may be formed by baking the wafer at about 400°C to about 950°C, preferably at about 750°C to about 950°C, for about 30 seconds to about 50 seconds.

Next, the present invention will be described in more detail with reference to examples obtained by the method of manufacture according to the present invention. However, it should be noted that these examples are provided for illustration only and are not to be construed in any way as limiting the invention.

## EXAMPLES

### Examples 1 to 5 and Comparative Examples 1 to 3

### Example 1

As an organic binder, 0.7 wt% of ethyl cellulose (STD4, SDT200, Dow Chemical Company) was sufficiently dissolved in 3.3 wt% of Texanol at 60°C to prepare an organic vehicle, and 88 wt% of spherical silver powder (AG-4-8, Dowa Hightech Co., Ltd.) having an average particle diameter of 2.0 $\mu$m, 2.7 wt% of a low melting point crystalline glass powder (Pb-Bi-Te-O) having an average particle diameter of 1.0 $\mu$m and a transition point of 280°C, 0.6 wt% of a dispersant BYK145 (BYK-Chemie), and 0.4 wt% of a thixotropic agent Thixatrol ST (Elementis Co.) were added to the organic vehicle, followed by mixing and kneading in a 3-roll kneader, thereby preparing a composition for solar cell electrodes.

The composition was printed in a predetermined pattern over a front surface of a wafer by screen-printing. Properties of the composition were measured by the following method and results are shown in the following Table 2.

### Examples 2 to 5 and Comparative Examples 1 to 3

Compositions for solar cell electrodes were prepared in the same manner as in Example 1 except that the components of the compositions were used in amounts as listed in Table 1. Thereafter, the compositions were printed by screen-printing

### Property Measurement

o Measurement of thixotropic index (TI): Thixotropic index was calculated using the ratio of viscosity values measured at 23°C using a No. 14 spindle by a rotary viscometer HBDV-II+Pro (Brookfield Co., Ltd.). For measurement of viscosity, a sample cup was completely filled with a specimen and equipped with the spindle. After temperature stabilization for 5 minutes, viscosity was measured at the following maintenance time.

**Table 1**

|  | 1 rpm | 2 rpm | 5 rpm | 10 rpm | 20 rpm | 50 rpm | 100 rpm |
|---|---|---|---|---|---|---|---|
| Maintenance time | 60 sec | 30 sec | 15 sec | 15 sec | 15 sec | 15 sec | 15 sec |

Based on the measured viscosity values, thixotropic indices in Formulae 1 to 4 and change rates of thixotropic index in Formulae 5 to 7 were calculated. Results are shown in Table 1 and Fig 1.

### Methods of Property Evaluation

o Measurement of serial resistance, short circuit current, and conversion efficiency: The compositions prepared in Examples and Comparative Examples were deposited over a front surface of a mono crystalline wafer by screen printing in a predetermined pattern, followed by drying in an IR drying furnace. Cells formed according to this procedure were subjected to baking at 600°C to 900°C for 60 seconds to 210 seconds in a belt-type baking furnace, and evaluated as to conversion efficiency (%), short circuit current (Isc), and serial resistance (Rs) using a solar cell efficiency tester CT-801 (Pasan Co., Ltd).

o Measurement of printability: Each of the compositions for solar cell electrodes prepared as above was printed in a predetermined pattern over a surface of a wafer using a screen mask designed to have a linewidth of 30 μm by screen-printing. The printed wafer was dried, baked, and observed at 9 portions of the pattern through a three-dimensional microscope, followed by confirmation of disconnection of the pattern through an EL analyzer.

∘ Measurement of aspect ratio: Each of the compositions for solar cell electrodes prepared as above was printed in a predetermined pattern over a surface of a wafer using a screen mask designed to have a linewidth of 30 μm by screen-printing. The printed wafer was dried, baked, and observed at 9 portions of the pattern through a three-dimensional microscope. The aspect ratio was obtained as an average value.

**Table 2**

|  |  | Example 1 | Example 2 | Example 3 | Example 4 | Example 5 | Comp. Example 1 | Comp. Example 2 | Comp. Example 3 |
|---|---|---|---|---|---|---|---|---|---|
| (A) Conductive powder | | 88 | 88 | 88 | 88 | 88 | 89 | 88 | 88 |
| (B) Glass frit | | 2.7 | 2.7 | 2.5 | 2.7 | 3.5 | 2.1 | 3 | 2.7 |
| (C) Organic vehicle | Organic binder | 0.7 | 1.2 | 0.8 | 0.6 | 0.7 | 0.5 | 0.8 | 0.6 |
| | Solvent | 3.3 | 3.1 | 3.4 | 2.9 | 3.3 | 2.6 | 3.7 | 3.4 |
| (D) Thixotropic agent | | 0.4 | 0.4 | 0.4 | 0.4 | 0.5 | 0.5 | 0.3 | 0.4 |
| (E) Additive | | 4.9 | 4.6 | 4.9 | 5.4 | 4 | 5.3 | 4.2 | 4.9 |
| TI | TI 10 | 4.12 | 4.61 | 4.76 | 5.21 | 4.02 | 1.63 | 2.93 | 2.73 |
| | TI 20 | 5.91 | 6.34 | 6.33 | 6.60 | 5.86 | 2.79 | 4.71 | 4.52 |
| | TI 50 | 6.86 | 7.02 | 7.28 | 7.32 | 6.63 | 5.53 | 7.70 | 6.71 |
| | TI 100 | 7.40 | 7.01 | 7.21 | 7.28 | 7.30 | 5.74 | 7.82 | 7.04 |
| |TI 10-TI 20| | | 1.79 | 1.73 | 1.57 | 1.39 | 1.84 | 1.16 | 1.79 | 1.79 |
| |TI 20-TI 50| | | 0.95 | 0.68 | 0.95 | 0.72 | 0.77 | 2.75 | 2.99 | 2.19 |
| |TI 50-TI 100| | | 0.54 | 0.00 | 0.00 | 0.00 | 0.67 | 0.20 | 0.11 | 0.33 |
| Short circuit current [A] | | 8.739 | 8.745 | 8.732 | 8.754 | 8.756 | 8.723 | 8.692 | 8.809 |
| Serial resistance [mohm] | | 4.93 | 4.95 | 4.94 | 4.98 | 5.04 | 5.23 | 5.03 | 7.22 |
| Conversion efficiency (%) | | 17.35 | 17.45 | 17.30 | 17.40 | 17.32 | 17.1 | 16.9 | 16.42 |
| 30 $\mu$m printability (number of disconnected lines) | | <10 | <10 | <10 | <10 | <10 | <20 | <20 | >40 |
| Aspect ratio (higher values are better) | | 0.17 | 0.16 | 0.17 | 0.16 | 0.18 | 0.15 | 0.14 | 0.18 |

As shown in result of Table 2 and the graph in Fig. 1, it was ascertained that the compositions prepared in Examples 1 to 5, which satisfy Formulae 1 to 7, had excellent fine pattern printability, and the solar cell electrodes prepared using the compositions had low serial resistance and high conversion efficiency.

**Claims**

1. A method of manufacture a composition for solar cell electrodes comprising mixing :

   - 50 wt% to 90 wt% of a conductive powder, wherein the conductive powder comprises at least one selected from the group consisting of silver (Ag), gold (Au), palladium (Pd), platinum (Pt), copper (Cu), chromium (Cr), cobalt (Co), aluminum (Al), tin (Sn), lead (Pb), zinc (Zn), iron (Fe), iridium (Ir), osmium (Os), rhodium (Rh), tungsten (W), molybdenum (Mo), nickel (Ni), and indium tin oxide (ITO),
   - 1 wt% to 15 wt% of a glass frit, wherein the glass frit comprises leaded glass frits, lead-free glass frits, or mixtures thereof,
   - 3 wt% to 40 wt% of an organic vehicle, wherein the organic vehicle comprises a binder resin and a solvent, and
   - 0.01 wt% to 2 wt% of a thixotropic agent, wherein the thixotropic agent comprises at least one selected from the group consisting of amine compounds, castor oil compounds, carbon black compounds, fatty acid amide compounds, fumed silica compounds, organo clay compounds, and nano-scale organic/inorganic particles, wherein the method steps of the composition satisfying the following Formulae 1 to 7:

   [Formula 1]

   $$3 < TI\ 10 = (\text{viscosity at 1 rpm/viscosity at 10 rpm}) < 5.5;$$

   [Formula 2]

   $$4 < TI\ 20 = (\text{viscosity at 2 rpm/viscosity at 20 rpm}) < 7;$$

   [Formula 3]

   $$6 < TI\ 50 = (\text{viscosity at 5 rpm/viscosity at 50 rpm}) < 7.5;$$

   [Formula 4]

   $$6 < TI\ 100 = (\text{viscosity at 10 rpm/viscosity at 100 rpm}) < 7.5;$$

   [Formula 5]

   $$1 < |TI\ 10\text{-}TI\ 20| < 2;$$

   [Formula 6]

   $$0.5 < |TI\ 20\text{-}TI\ 50| < 1.5;$$

   and

   [Formula 7]

   $$0 \leq |TI\ 50\text{-}TI\ 100| < 0.8,$$

where in formulae 1 to 7, a thixotropic index (TI) is calculated by substituting viscosity values measured at each revolutions per minute (rpm) using a No. 14 spindle by a rotary viscometer at 23°C, after temperature stabilization for 5 minutes, viscosity is measured at the following maintenance time 1 rpm 60 sec, 2 rpm 30 sec, 5 rpm 15 sec, 10 rpm 15 sec, 20 rpm 15 sec, 50 rpm 15 sec and 100 rpm 15 sec.

2. The method of manufacture of the composition according to claim 1, wherein the glass frit has an average particle diameter (D50) of 0.1 $\mu$m to 5 $\mu$m.

3. The method of manufacture of the composition according to claim 1, wherein the composition comprises at least one additive selected from the group consisting of dispersants, plasticizers, viscosity stabilizers, anti-foaming agents, pigments, UV stabilizers, antioxidants, and coupling agents.

4. The method of manufacture of the composition according to any one of claims 1 to 3, wherein a pattern printed with the composition has a linewidth of 75 $\mu$m to 90 $\mu$m, a line thickness of 15 $\mu$m to 20 $\mu$m, and an aspect ratio (line thickness/linewidth) of 0.15 or more.

5. A solar cell electrode produced from the composition for solar cell electrodes obtained by a method of manufacture according to any one of claims 1 to 4.

**Patentansprüche**

1. Verfahren zur Herstellung einer Zusammensetzung für Solarzellenelektroden, umfassend das Mischen von:

- 50 Gew.-% bis 90 Gew.-% eines leitfähigen Pulvers, wobei das leitfähige Pulver mindestens eines aus der Gruppe bestehend aus Silber (Ag), Gold (Au), Palladium (Pd), Platin (Pt), Kupfer (Cu), Chrom (Cr), Cobalt (Co), Aluminium (Al), Zinn (Sn), Blei (Pb), Zink (Zn), Eisen (Fe), Iridium (Ir), Osmium (Os), Rhodium (Rh), Wolfram (W), Molybdän (Mo), Nickel (Ni) und Indiumzinnoxid (ITO) umfasst,
- 1 Gew.-% bis 15 Gew.-% einer Glasfritte, wobei die Glasfritte bleihaltige Glasfritten, bleifreie Glasfritten oder Mischungen davon umfasst,
- 3 Gew.-% bis 40 Gew.-% eines organischen Vehikels, wobei das organische Vehikel ein Bindemittelharz und ein Lösungsmittel umfasst, und
- 0,01 Gew.-% bis 2 Gew.-% eines Thixotropiermittels, wobei das Thixotropiermittel mindestens ein aus der Gruppe bestehend aus Aminverbindungen, Rizinusölverbindungen, Rußverbindungen, Fettsäureamidverbindungen, pyrogen hergestellten Kieselsäureverbindungen, Organotonverbindungen und nanoskaligen organisch/anorganischen Teilchen umfasst, wobei die Verfahrensschritte der Zusammensetzung die folgenden Formeln 1 bis 7 erfüllen:

```
[Formel 1]
3 < TI 10 = (Viskosität bei 1 UpM/Viskosität bei
10 UpM) < 5,5;


[Formel 2]
4 < TI 20 = (Viskosität bei 2 UpM/Viskosität bei
20 UpM) < 7;


[Formel 3]
6 < TI 50 = (Viskosität bei 5 UpM/Viskosität bei
50 UpM) < 7,5;
```

[Formel 4]

$6 < TI\ 100 = (Viskosität\ bei\ 10\ UpM/Viskosität\ bei\ 100\ UpM) < 7,5;$

[Formel 5]

$1 < |TI\ 10-TI\ 20| < 2;$

[Formel 6]

$0,5 < |TI\ 20-TI\ 50| < 1,5$

und

[Formel 7]

$1 \leq |TI\ 50-TI\ 100| < 0,8,$

wobei in den Formeln 1 bis 7 ein Thixotropieindex (TI) durch Einsetzen von bei den jeweiligen Umdrehungen pro Minute (UpM) unter Verwendung einer Spindel Nr. 14 auf einem Rotationsviskosimeter bei 23 °C nach 5 Minuten Temperaturstabilisierung gemessenen Viskositätswerten berechnet wird und die Viskosität bei der folgenden Haltezeit gemessen wird: 1 UpM 60 s, 2 UpM 30 s, 5 UpM 15 s, 10 UpM 15 s, 20 UpM 15s, 50 UpM 15 s und 100 UpM 15 s.

2. Verfahren zur Herstellung der Zusammensetzung nach Anspruch 1, wobei die Glasfritte einen mittleren Teilchendurchmesser (D50) von 0,1 $\mu$m bis 5 $\mu$m aufweist.

3. Verfahren zur Herstellung der Zusammensetzung nach Anspruch 1, wobei die Zusammensetzung mindestens ein Additiv aus der Gruppe bestehend aus Dispergiermitteln, Weichmachern, Viskositätsstabilisatoren, Antischaummitteln, Pigmenten, UV-Stabilisatoren, Antioxidantien und Haftvermittlern umfasst.

4. Verfahren zur Herstellung der Zusammensetzung nach einem der Ansprüche 1 bis 3, wobei ein mit der Zusammensetzung gedrucktes Muster eine Linienbreite von 75 $\mu$m bis 90 $\mu$m, eine Liniendicke von 15 $\mu$m bis 20 $\mu$m und ein Aspektverhältnis (Liniendicke/Linienbreite) von 0,15 oder mehr aufweist.

5. Solarzellenelektrode, hergestellt aus der nach einem Herstellungsverfahren nach einem der Ansprüche 1 bis 4 erhaltenen Zusammensetzung für Solarzellenelektroden.

**Revendications**

1. Procédé de fabrication d'une composition pour des électrodes de cellule solaire comprenant le mélange :

- de 50 % en poids à 90 % en poids d'une poudre conductrice, la poudre conductrice comprenant au moins l'un choisi dans le groupe constitué par l'argent (Ag), l'or (Au), le palladium (Pd), le platine (Pt), le cuivre (Cu), le chrome (Cr) le cobalt (Co), l'aluminium (Al), l'étain (Sn), le plomb (Pb), le zinc (Zn), le fer (Fe), l'iridium (Ir), l'osmium (Os), le rhodium (Rh), le tungstène (W), le molybdène (Mo), le nickel (Ni), et l'oxyde d'indium-étain (ITO),
- 1 % en poids à 15 % en poids d'un fritté de verre comprenant des frittés de verre plombé, des frittés de verre exempt de plomb, ou des mélanges correspondants,
- 3 % en poids à 40 % en poids d'un véhicule organique, le véhicule organique comprenant une résine de liant et un solvant, et
- 0,01 % en poids à 2 % en poids d'un agent thixotropique, l'agent thixotropique comprenant au moins l'un choisi dans le groupe constitué par des composés de type amine, des composés de type huile de ricin, des composés de type noir de carbone, des composés de type amide d'acide gras, des composés de type silice fumée, des composés de type organoargile, et des particules nanométriques organiques/inorganiques,

les étapes de procédé de la composition satisfaisant les formules suivantes 1 à 7 :

[Formule 1]
3 < TI 10 = (viscosité à 1 tpm/viscosité à 10 tpm) < 5,5 ;

[Formule 2]
4 < TI 20 = (viscosité à 2 tpm/viscosité à 20 tpm) < 7 ;

[Formule 3]
6 < TI 50 = (viscosité à 5 tpm/viscosité à 50 tpm) < 7,5 ;

[Formule 4]
6 < TI 100 = (viscosité à 10 tpm/viscosité à 10 tpm) < 7,5 ;

[Formule 5]
1 < ⎮TI 10-TI 20⎮ < 2 ;

[Formule 6]
0,5 < ⎮TI 20-TI 50⎮ < 1,5 ;

et

[Formule 7]
0 ≤ ⎮TI 50-TI 100⎮ < 0,8,

dans lequel dans les formules 1 à 7, un indice thixotropique (TI) est calculé par substitution de valeurs de viscosité à chaque tour par minute (tpm) à l'aide d'une tige n° 14 par un viscosimètre rotatif à 23 °C, après une stabilisation de température pendant 5 minutes, la viscosité étant mesurée au temps de maintenance suivant 1 tpm 60 sec, 2 tpm 30 sec, 5 tpm 15 sec, 10 tpm 15 sec, 20 tpm 15 sec, 50 tpm 15 sec et 100 tpm 15 sec.

2. Procédé de fabrication de la composition selon la revendication 1, le fritté de verre possédant un diamètre moyen de particule (D50) de 0,1 μm à 5 μm.

3. Procédé de fabrication de la composition selon la revendication 1, la composition comprenant au moins un additif choisi dans le groupe constitué par des dispersants, des plastifiants, des stabilisants de viscosité, des agents antimousses, des pigments, des stabilisants UV, des antioxydants, et des agents de couplage.

4. Procédé de fabrication de la composition selon l'une quelconque des revendications 1 à 3, un motif imprimé avec la composition possédant une largeur de ligne de 75 μm à 90 μm, une épaisseur de ligne de 15 μm à 20 μm, et un rapport d'aspect (épaisseur de ligne/largeur de ligne) de 0,15 ou plus.

5. Électrode de cellule solaire produite à partir de la composition pour électrodes de cellule solaire obtenue par un procédé de fabrication selon l'une quelconque des revendications 1 à 4.

【Figure 1】

【Figure 2】

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- WO 2012135551 A1
- EP 2490228 A2
- WO 2009157727 A2
- JP 2011228481 A
- JP 2004355862 A
- KR 20110040713 A
- KR 20100069950 A
- KR 20070055489 A